# EUROPEAN PATENT APPLICATION

(11) **EP 4 592 750 A2**
(43) Date of publication of application: **30.07.2025**
(21) Application number: 25166564.2
(22) Date of filing: 27.03.2025
(51) Int. Cl.: G03F 7/00, G03F 9/00

(54) **SENSOR SYSTEM AND METHOD FOR SENSING AND LITHOGRAPHIC APPARATUS PROVIDED WITH THE SENSOR SYSTEM**

(71) Applicant: ASML Netherlands B.V., 5500 AH Veldhoven (NL)
(72) Inventor: SCHIRRING, Florian, Axel, 5500 AH Veldhoven (NL); LOOMAN, Joris, Maria, Gerardus, 5500 AH Veldhoven (NL); LIN, Yin, 5500 AH Veldhoven (NL)
(74) Representative: ASML Netherlands B.V.

(57) **Abstract**

The present disclosure provides a sensor system for use in a lithographic apparatus, the sensor system comprising: - a cooling system to be embedded in a base; - a detector holder provided with a detector and having supports to be connected to the base; - a heat sink connected to the cooling system, the heat sink being thermally disconnected from the detector holder; and - detector electronics thermally coupled to the heat sink for processing a detector signal received from the detector.

## Description

### FIELD

The present invention relates to a sensor system and method for sensing. The system and method may relate to a sensor in a lithographic apparatus, for instance relating to or positioned in the vicinity of an object stage. The sensor may be an image sensor.

### BACKGROUND

Light generated by means of a radiation source can be used by exposure apparatuses for semiconductor manufacturing processes. Examples of such exposure apparatuses are a lithographic apparatus, a metrology, or an inspection apparatus, more specifically a mask inspection apparatus and even more specifically an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (e.g., a photoresist or resist) provided on a substrate. To project a pattern on a substrate a lithographic apparatus may use electromagnetic radiation. The wavelength of this radiation determines the minimum size of features which can be formed on the substrate. A lithographic apparatus, which uses EUV radiation, having a wavelength within the range 4-20 nm, for example 6.7 nm or 13.5 nm, may be used to form smaller features on a substrate than a lithographic apparatus which uses, for example, radiation with a wavelength of 193 nm.

An (actinic) mask inspection apparatus is an apparatus that is configured for measuring dimensions or detecting defects in masks or mask blanks. EUV lithography uses a reflective surfaces instead of a lenses as optics. Mask blanks used in EUV lithography generally have a multilayer structure which functions as a Bragg reflector, the multilayers may be alternatingly Molybdenum and Silicon. If a defect exists in this structure, the projected pattern will be deformed in the lithographic process. Therefore, mask inspection to check whether a defect is present is considered a requirement for a mass-production process. EUV mask inspection may be used for several purposes and in several different stages. Firstly, it can be used for the detection of phase defects that may occur in mask blanks. Such phase defects may occur during the manufacturing of the multilayer stack of the mask blank. If undetected, these phase defects are printed on all chips printed with the part of a mask containing the phase defects. Such phase defects may be correctly detected by using the same or similar (13.5nm) actinic EUV wavelength as the lithography tool. Secondly, mask inspection can be used for patterned mask inspection and can be carried out for the quality control of EUV patterned masks. For example, the mask inspection can be used to measure critical dimensions on the mask blank. In addition to phase defects, absorber pattern defects on the surface can be detected. Thirdly, mask inspection can be used for simulating exposure and determining the deterioration of optical contrast of a defect detected in the actinic inspection. Forth, the mask inspection can be used for optical proximity correction (OPC) evaluation or during mask repair process so as to improve pattern transfer fidelity. Further, it can be used for inspecting optical contrast after fixing the defect. In addition to the above, mask inspection can also be used to measure small particle/amplitude effects.

A lithographic apparatus typically comprises one or more sensors, such as an image sensor, to ensure that the image of the mask is correctly projected onto the substrate. The sensors may, for instance, include a transmissive image sensor (TIS) which detects the position of an aerial image of a grating as projected by the projection system. Such a sensor is typically mounted to the substrate stage to enable alignment of the mask or reticle and the substrate. The sensors may include an alignment sensor or an illumination sensor.

Despite measures to limit thermal loading, in practice, during operation the sensor may deform due to a heat load on the sensor and related electronics. The deformation due to thermal load creates an uncertainty about the position of the respective sensor relative to the substrate on the stage, which consequently decreases the overlay accuracy of respective layers.

It is an aim to provide a sensor and method to improve on at least some of the problems associated with the prior art.

### SUMMARY

The present disclosure provides a sensor system for use in a lithographic apparatus, the sensor system comprising:
- a cooling system configured to be embedded in an object table;
- a detector holder provided with a detector and having supports configured to be connected to the object table;
- a heat sink connected to the cooling system, the heat sink being thermally disconnected from the detector holder;
- detector electronics thermally coupled to the heat sink for processing a detector signal received from the detector.

In an embodiment, the system comprises a thermal link connected between the detector holder and the cooling system.

In an embodiment, the detector comprises an image sensor.

In an embodiment, the thermal link is compliant.

In an embodiment, the detector holder and the detector electronics are connected via a flexible cable for transmitting the detector signal.

In an embodiment, the detector holder and the detector electronics are thermally disconnected from each other.

In an embodiment, the heat sink is arranged between the detector holder and the cooling system.

In an embodiment, the system comprises one or more supports connecting the detector holder to an equipment element. In an embodiment, the equipment element is provided with the cooling system. The one or more supports herein are connected to the equipment element without being directly connected to the cooling system. Thus, potential vibrations caused by flow of cooling fluid in the cooling system are obviated from reaching the supports and the detector holder connected to said supports.

In an embodiment, the cooling system is a cooling medium based cooling system, the cooling system being adapted to direct flow of the cooling medium first for cooling the detector holder and subsequently for cooling the heat sink.

In an embodiment, the cooling system comprises a first cooling section for cooling the detector holder, and a second cooling section connected to the first cooling section for cooling the heat sink.

In an embodiment, the system comprises a thermal interface material thermally connecting an inner surface of the heat sink to the detector electronics.

According to another aspect, the disclosure provides an object stage, comprising:
- at least one sensor system comprising:
- a cooling system;
- a detector holder provided with a detector and connected to the object stage;
- a heat sink connected to the cooling system, the heat sink being thermally disconnected from the detector holder;
- detector electronics thermally coupled to the heat sink for processing a detector signal received from the detector; and
- a thermal link connected between the detector holder and the cooling system.

In an embodiment, the detector of the at least one sensor system is an image sensor.

According to another aspect, the disclosure provides a lithographic apparatus comprising at least one object stage as described above.

In an embodiment, the lithographic apparatus comprises a source of radiation for exposure of a pattern on a substrate, the radiation being in the extreme ultraviolet (EUV) spectrum.

According to another aspect, the disclosure provides a method for sensing in a lithographic apparatus, the method comprising:
- providing an object stage having at least one sensor system, the sensor system comprising:
- a cooling system;
- a detector holder provided with a detector and connect to the object stage;
- a heat sink connected to the cooling system, the heat sink being thermally disconnected from the detector holder;
- detector electronics thermally coupled to the heat sink for processing a detector signal received from the detector; and
- a thermal link connected between the detector holder and the cooling system.

In an embodiment, the method comprises the step of directing a flow of cooling medium through the cooling system to first cool the thermal link to the detector holder and subsequently to cool the heat sink.

### BRIEF DESCRIPTION OF THE DRAWINGS

Embodiments of the invention will now be described, by way of example only, with reference to the accompanying schematic drawings, in which:
- Figure 1 shows a schematical representation of a lithographic system comprising a lithographic apparatus and a radiation source;
- Figure 2 shows a schematical representation of a system for (actinic) mask inspection;
- Figure 3 shows a schematical representation of an alternative radiation source;
- Figure 4A shows a side view of a measurement side of a lithographic apparatus;
- Figure 4B shows a side view of an expose side of a lithographic apparatus;
- Figure 5 shows a perspective view of an exemplary method for scanning an image align sensor;
- Figure 6 shows a schematical representation in cross sectional side view of an exemplary sensor system and a sensor system according to an embodiment;
- Figure 7 shows a schematical representation in cross sectional side view of a sensor system according to an embodiment; and
- Figure 8 shows a diagram exemplifying thermal decoupling of a sensor system according to an embodiment.

### DETAILED DESCRIPTION

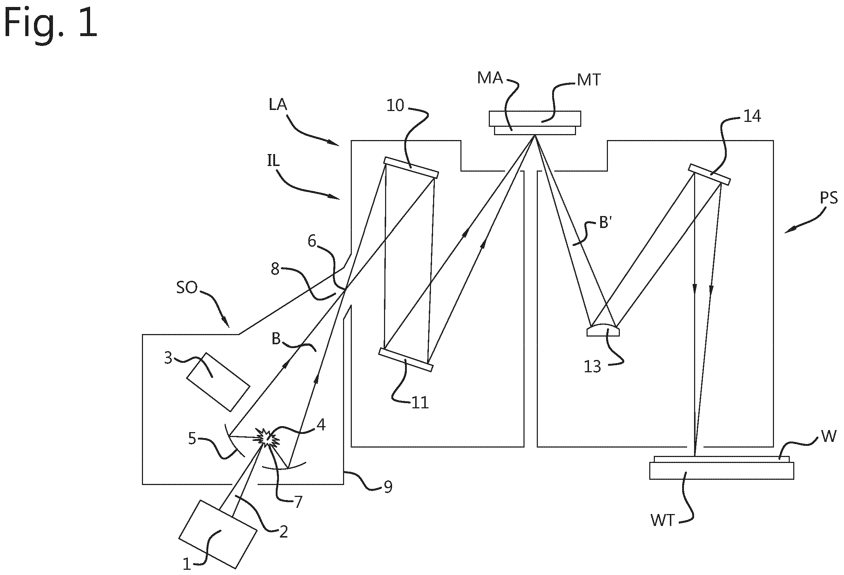

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The lithographic apparatus LA and radiation source SO described herein can be used in method for performing a circuit layout patterning process. A circuit layout patterning method comprises receiving a substrate with a photoresist layer. The method further comprises directing EUV radiation from radiation source to the photoresist layer to form a patterned photoresist layer. The method further comprises developing and etching the patterned photoresist layer to form a circuit layout.

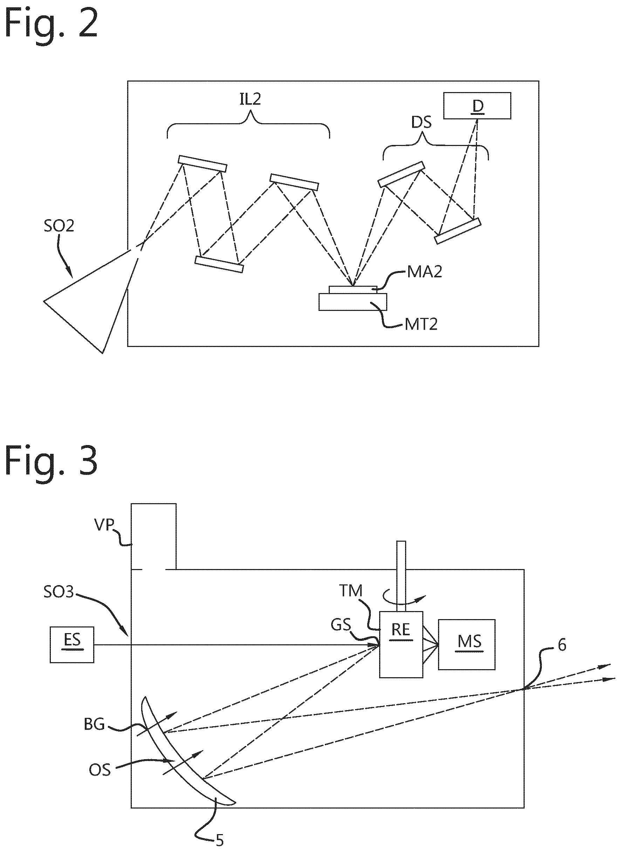

Figure 2 depicts a system for (actinic) mask inspection. A mask inspection system can be used to identify or inspect defects in a mask to be used in a lithographic process by means of an apparatus described in figure 1. The mask inspection system comprises a radiation source SO2 and an illumination system IL2 and a detection system DS. A mask MA2 is placed on a mask stage MT2 and illuminated by the illumination system IL2 reflecting radiation incident from the radiation source SO2. The radiation coming from the illuminated mask is reflected by the detection system DS. In this way an image is formed on a detector D.

The radiation source SO shown in Figure 1 is, for example, of a type which may be referred to as a laser produced plasma (LPP) source. A laser system 1, which may, for example, include a CO2¬ laser, is arranged to deposit energy via a laser beam 2 into a fuel (i.e., a target material), such as tin (Sn) which is provided from, e.g., a fuel generator 3. Although tin is referred to in the following description, any suitable fuel may be used. The fuel may, for example, be in liquid form, and may, for example, be a metal or alloy. The fuel generator 3 may comprise a nozzle configured to direct the fuel, e.g. in the form of droplets, along a trajectory towards a plasma formation region 4. The laser beam 2 is incident upon the fuel at the plasma formation region 4. The deposition of laser energy into the tin creates a plasma 7 at the plasma formation region 4. Radiation, including EUV radiation, is emitted from the plasma 7 during de-excitation and recombination of electrons with ions of the plasma 7.

The EUV radiation from the plasma 7 is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a free electron laser (FEL) or a discharge produced plasma (DPP) source may be used to generate EUV radiation.

Figure 3 depicts an alternative radiation source SO3. For generating plasma target material TM, like tin or xenon may be provided to a rotating element RE, like for example rotating wheels, cylinder, or a drum or variations thereof. Target material may be provided in liquified form to the one or more rotating elements, e.g. by means of a target material bath. Alternatively, target material may also be provided in solid or frozen form (e.g. Xenon). Gaseous target material may be sprayed onto the rotating element to replace target material transformed to plasma. According to embodiments the rotating element would be cold enough to solidify the target material. An excitation device ES may be used to assist in plasma formation. According to embodiments this excitation device is a laser, like a solid-state or gas laser. Reflective optics OS, like one or more mirrors, can be used to reflect the EUV light generated to the intermediate focus 6. According to embodiments, the reflective optics comprise a collector mirror. Buffer gas flow BG may be provided to mitigate debris present in the radiation source. Also a vacuum pump VP may be provided to remove gas from the radiation source SO3.

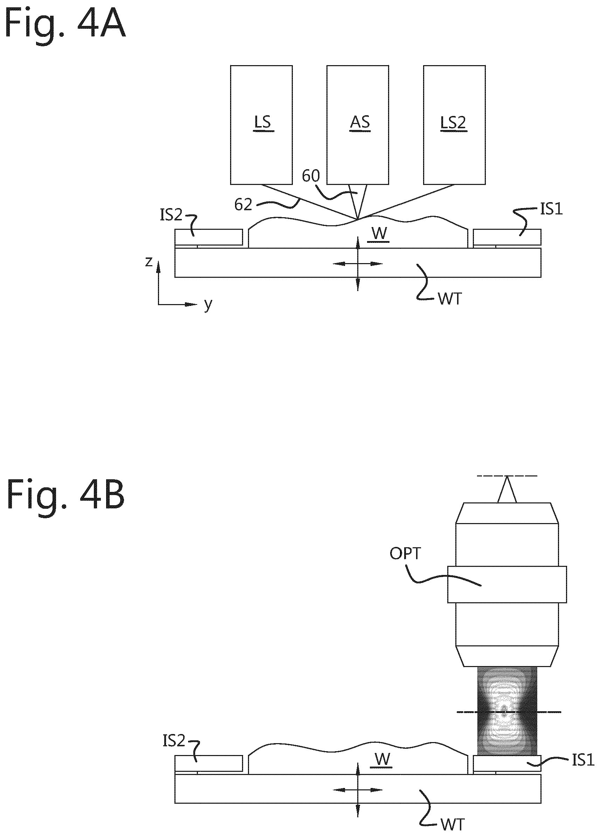

Referring to Figures 4A and 4B, the lithographic apparatus may include an object stage including one or more movable object tables WT. The object table WT is typically movable with respect to a base (not shown). In operation, the object table WT may be provided with a substrate W. Then, the object table WT first moves towards a measurement location or measurement side, exemplified in Figure 4A. Thereafter, the object tables moves to the expose side, see Figure 4B.

Although both Figures are shown as separate Figures, please note that the measurement side (Fig. 4A) and the expose aside (Fig. 4B) may typically be located on opposite sides of the same base, with one or more substrate tables being able to move from side to side.

For technical details of an object stage comprising multiple object tables, and the functionality thereof including measurement and exposure, reference is made to, for instance, patent US-6597433.

The object table is typically provided with one or more first sensors. The first sensors are image align sensors, such as a first image align sensor IS1 and a second image align sensor IS2. The first sensors are typically arranged relatively near to, or adjacent to, the intended position of the substrate W.

The measurement side of the object stage, see Fig. 4A, is typically provided with a number of other sensors. The measurement side may be provided with one or more of a second sensor and a third sensor. The second sensor may comprise an alignment sensor AS. The third sensor may comprise a level sensor LS. The level sensor LS, which also comprises a second part or detector part LS2, is adapted to measure height or topography of the object W on the object table. The alignment sensor AS may measure the alignment, i.e. the horizontal position in one or both of the x-direction and y-direction, of the object W with respect to a predetermined setpoint position.

The alignment sensor AS may include a light source. The light source may be a source of second radiation 60, for instance visible light. The visible light frequency may be somewhere in the 400 THz to 700 THz frequency range, approximately. Alternatively worded, visible light herein may have a wavelength in the spectrum of about 380 to about 750 nanometers. In use, an alignment mark on the object W is irradiated, for instance using the visible light. The reflected light is captured to assess a position of the mark.

The level sensor comprises a first part LS and a second part LS2. The first part may comprise a source of third radiation 62. The third radiation may be any suitable radiation for scanning the top surface of the substrate W. In use, the first level sensor part LS directs the third radiation 62 at the top surface of the substrate W. Herein, the top surface is the surface of the substrate W facing the level sensor and the alignment sensor, and facing away from the object table WT. The level sensor may scan the third radiation across the surface of the substrate, in a predetermined pattern. The second level sensor part LS2 may detect the third radiation as it is reflected from the top surface, and use the detected reflection to determine the topology or height map of the top surface of the substrate W.

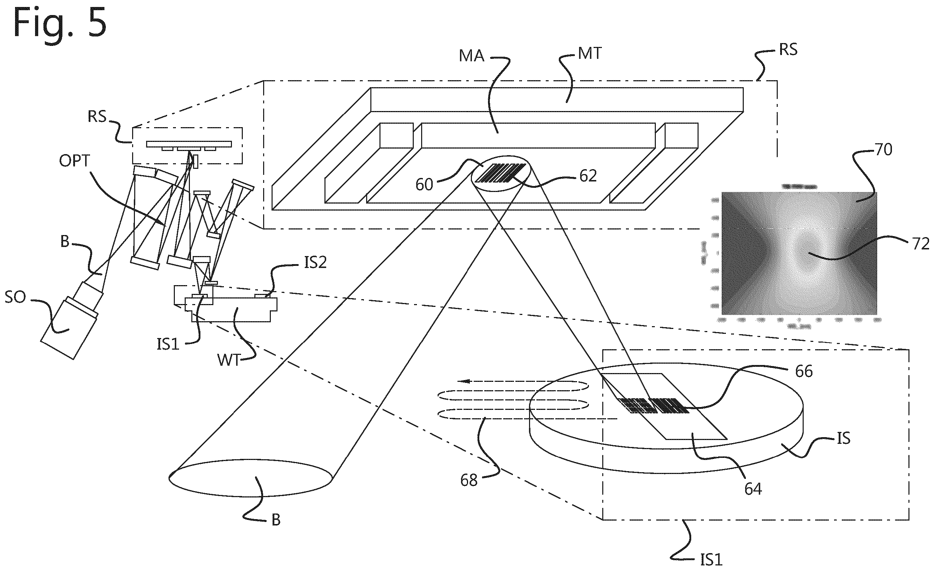

Figure 5 schematically depicts the general working principle of the one or more image align sensors IS. Herein, an aerial image 60 is formed at reticle level from grating marks 62 on the mask MA or one of its related components. Herein, for an EUV based application the mark may be referred to as a reticle. The functional stage comprising the reticle and its related object table MT may be referred to as the reticle stage RS.

The image 60 is then projected via the optics OPT of the lithographic apparatus onto the object stage. Herein, at least one of the image align sensors IS is positioned at the receiving end of the projection optics OPT. The image 60 is projected on the image align sensor IS, forming a projected image. The image align sensor comprises a photodetector 64 for detecting the projected image. The photodetector is provided with photodetector gratings 66.

In operation, the first sensor IS is moved across the projected beam B in accordance with a predetermined pattern 68. The pattern 68 may typically extend in horizontal direction (x-axis) and in vertical direction (z-axis), thus enabling to create an indication of radiation intensity 70 including an area of maximum radiation intensity 72. The indication of radiation intensity may be referred to as an areal image. The image align sensor basically scans the projected image, to find a position wherein the photodetector gratings 66 are aligned with the reticle gratings 62. The image align sensor IS herein provides the areal image 70. At the respective position of the object table where the respective gratings 62, 66 align, the areal image provides the maximum 72.

In general, alignment marks or gratings may include a series of lines on the respective carrier, such as a section of the image align sensor, a section of the reticle, in the resist applied to a substrate W, or on a section of the wavefront sensor. Incoming alignment sensor radiation diffracts on these lines. The diffracted light is optically processed, typically by the alignment sensor AS, to make the signal sensitive to the mark position, i.e the position of the respective grating. The mark pattern is created by moving the respective mark with respect to the respective sensor.

Measurement errors by any of the sensors as described above may result in patterning errors, wherein the irradiated pattern on the substrate deviates from an optimum. The latter may generally be referred to as performance drift, which typically may result in overlay errors. An overlay error is a displacement of a printed layer with respect to a target location, which typically matches with a previously printed layer.

As schematically indicated in Figure 5, the sensors are crucial to the lithography process. Herein, the stability of positioning of marks and gratings requires careful focus on structural and thermal aspects of the design. For instance, the illumination sensor IS1 provides reference marks and gratings which are critical to sensing the position of the wafer W with respect to the pattern and optics.

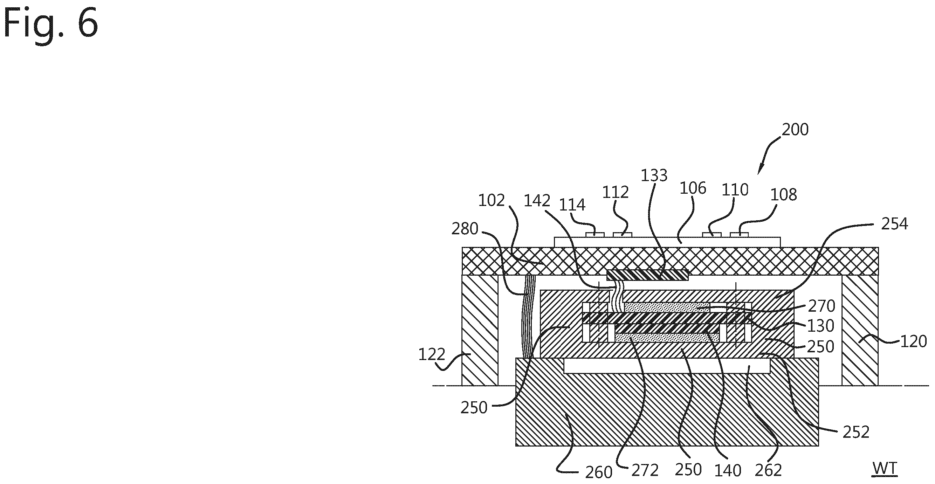

Generally referring to Figure 6, a sensor system 200 in accordance with an embodiment of the present disclosure is schematically shown. Such a sensor or sensor system 200, such as the IS sensor, typically includes a detector holder 102. The detector holder 102 can also be referred to as a carrier structure 102. Other components are attached to this carrier structure 102. For instance, a sensor structure 106 or detector 106 may be connected to the detector holder 102. The sensor structure 106 may be provided with sensor components, such as one or more marks 108, 114 and/or one or more gratings 108, 114. The sensor structure 106 may also comprise one or more detectors or other components, such as EUV diodes.

In the embodiment as shown, the detector holder or carrier structure 102 is arranged on, e.g. mounted on, one or more supports 120, 122, e.g. column like structures 120, 122. In accordance with the present disclosure, the supports 120, 122 are configure to be connected to an object table or equipment element, such as substrate table WT. The supports 120, 122 may be connected to the detector holder or carrier structure 102 and/or to the respective object table using a suitable connection. The supports or column like structures 120, 122 may e.g. function as flexure feet. The supports 120, 122 and/or the connections as used can be tuned to adjust for tolerances in height, to thereby adjust and optimize a position or orientation of the sensor structure or detector 106 within a certain range.

The sensor system 200 in accordance with an embodiment of the present disclosure comprises a heat sink 250. In the embodiment as shown, the heat sink 250, which may also be referred to as a heat capture structure 250, substantially fully encloses a control circuitry 130, 140 of the sensor system 200. The control circuitry 130, 140 may also be referred to as detector electronics and may serve to process any signal retrieved from e.g. a detector 106 mounted to the detector holder 102. In the embodiment as shown, the heat sink 250 includes a lower end 252 in direct contact with a cooling system 260.

In the embodiment as shown, the sensor system 200 comprises a cooling system 260 which is configured to dissipate heat from the heat sink 250. As shown, the cooling system 260 may be provided at an interface between an object table WT and the heat sink or heat capture structure 250. The cooling system 260 may include one or more channels 262. In operation, the cooling system 260 may cause a flow of a heat dissipating fluid or gas through the channels 262 to dissipate heat as received from the heat sink or heat capture structure 250, and to discharge the heat via the cooling system 260. As shown, the cooling system 260 is mounted to the object table WT, e.g. (partially) embedded in the object table WT.

It is also worth noting that the detector holder 102 has a mounting to the object table WT that is separate from the cooling system 260. By mounting the detector holder 102 via the supports 120, 122 to the object table WT, rather than mounting the detector holder 102 to the cooling system 260, a transmission of vibrations or disturbances of the cooling system 260 to the detector holder 102 can be avoided or mitigated.

The heat sink or heat capture system 250 has an upper end 254 covering the control circuits 130,140. The upper end 254 of the heat sink is separated from the carrier structure 102. Separated herein includes both structural and thermal separation. The upper end 254 of the heat sink is structurally disconnected from the carrier structure 102. The control circuits are still connected to the control board 133 via the signal line 142, which passes through an appropriate opening in the upper end 254 of the heat capture structure.

In a practical embodiment, the heat sink or heat capture structure 250 may be made of a metallic material, for instance aluminum. The sensor system of the present disclosure allows more tolerance to the heat capture structure, which therefore can me made of a relatively inexpensive material which, like aluminum, is relatively easy and cost effective to fabricate in the desired shape.

The sensor system 200 may include one or more layers of a thermal interface material 270, 272. A first layer 270 of thermal interface material may be arranged, for instance, in between a control circuit 130 and the upper end 254 of the heat capture structure 250. A second layer 272 of thermal interface material may be arranged, for instance, in between a control circuit 132 and the lower end 252 of the heat capture structure 250.

In a practical embodiment, the thermal interface material has a heat conductivity in the range of about 50 to 2000 W/m•K. The thermal interface material may include, but is not limited to, aluminum nitride. Aluminum nitride has a heat conductivity of about 310 W/m•K. Aluminum nitride is one of the few known materials to offer electrical insulation along with a high thermal conductivity. It has good thermal shock resistance and acts as an electrical insulator. Other thermally conductive pads may also be suitable.

The sensor system 200 includes a thermal link 280 between the cooling system 260 and the detector holder or carrier structure 102. The thermal link 280 comprises a material which has relatively high thermal conductivity. Said material may include one or more of, but are not limited to, a metal such as silver, copper, gold, aluminum, tungsten, graphite, or graphene. Heat conductivity of these materials is in the range of about 160 to 430 W/m•K. The thermal link 280 preferably has a relatively low stiffness. Herein, the link may be at least slightly flexible, allowing at least some movement of the carrier structure 102 with respect to the cooling system 260. In a practical embodiment, the thermal link 280 includes a thermally conductive material, which is also electrically conductive. Thus, the thermal link may also enable discharge of static electricity from the sensor board 106 and the carrier 102. Herein, said electrically and thermally conductive material may be enclosed by an electrically shielding material. The electrically shielding material may include an electrically non-conductive elastomer.

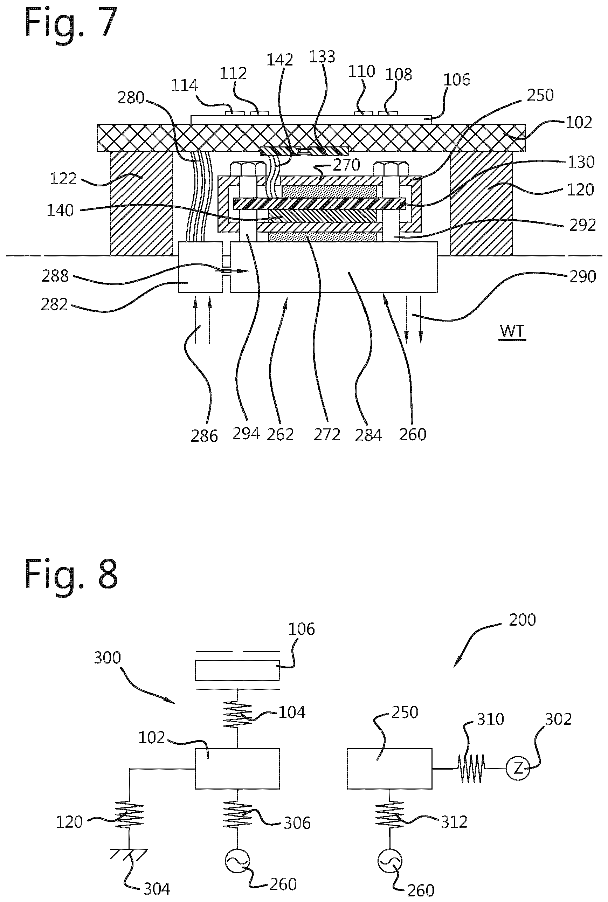

Generally referring to Figure 7, in an embodiment, the flow channel 262 of the cooling system 260 may comprise a first section 282 and a second section 284. In the embodiment as shown, the first section 282 is thermally connected to the thermal link 280. The second section 284 is thermally connected to the heat capture structure or heat sink 250.

In operation, a flow of cooling medium 286 is first directed to the first section 284. Herein, the thermal link 280 can discharge heat to the cooling medium. Subsequently, the flow 288 of the cooling medium is directed to the second section 284. Herein, the heat sink or heat capture structure 250 can discharge heat to the cooling medium. Subsequently, the flow 290, comprising heated cooling medium, is discharged for re-cooling.

In an embodiment, see Fig. 7, the heat sink 250 may be shaped as a container, enclosing at least part of the detector electronics. The container may be structurally and thermally connected to the cooling system 260. The heat sink 250 may be connected using, for instance, one or more metallic bolts 292, 294. Herein, a thermal pad 272, comprised of a thermally conductive material, may be arranged between an outer surface of the heat capture structure 250 and the cooling system 260. The thermal pad 272 improves the thermal connection to the cooling system, improving discharge of heat from the heat sink.

Generally referring to Figure 8, schematically, the sensor system 200 of the present disclosure thermally separates the sensor 300 from the related detector electronics 302. Herein, as described above, embodiments of the sensor 300 may comprise a sensor structure 106 thermally connected to the detector holder or carrier structure 102. The carrier structure 102 may be thermally connected, for instance via one or more supports, e.g. column structures, 120, to an equipment element 304. Element 304 may be a substrate table or an optical element such as a mirror block. The carrier structure 102 may also be thermally connected to the cooling system 260. The thermal connection 306 between the carrier structure 102 and the cooling system 260 may include the thermal link 280 as e.g. shown in Figures 6 and 7. The thermal connection 306 between the carrier 102 and the cooling system 260 may include a thermal interface material. Both the thermal interface material and the thermal link 280 may be combined.

The detector electronics 302 are thermally disconnected, and preferably thermally shielded, from the sensor 300. The thermal shielding may include a heat sink or heat capture structure 250 as described above. Herein, a signal line connects the electronics to the sensor, to allow transfer of electrical signals between the respective elements. Heat transfer of said signal line however may be limited in comparison to the other thermal connections available. The combination of heat sink and limited connection substantially obviates heat conduction from the detector electronics 302 to the sensor 300.

Heat from the detector electronics 302 is discharged via thermal connection 310 connecting the detector electronics to the heat sink 250. The thermal connection 310 may include the connecting elements 292, 294 and/or pads 270, 272 of thermal interface material (see Fig. 7). The heat sink 250 in turn can discharge heat to the cooling system 260 via thermal connection 312. Herein, the thermal connection 312 may include a direct connection (Fig. 6) and/or a thermal interface material (Fig. 7).

The present disclosure provides a solution to the issues referenced above by decoupling. The system and method of the present disclosure allow structural and thermal decoupling of the control circuits and the sensor elements. Thereby, the system and method achieve:
- obviate bending issues in the heat cup or electronics, as these are structurally not connected to the carrier 102 of the sensor 106;
- obviate thermal issues, as the system and method separate the thermal loop of the electronics from affecting the sensor, while also improving thermal management of the electronics; and
- improve dynamics, as the mass connected to the carrier structure 102 can be reduced by more than half, compared to a conventional system.

By separating the carrier structure or detector holder 102, which only carries the 'sensing' module or detector 106, from the detector electronics (i.e. the control circuits 130, 140), further benefits are also found in installation. In practice, typically, defectivities occur in the sensor structure 106, while the detector electronics 130, 140 are still able to continue going. The system of the present disclosure allows to replace only the sensor instead of the complete sensor module. Thus, the system and method of the present disclosure simplify replacement of the defect component, for instance either the sensor structure 106 or the electronic control circuits. The thermal link 280 allows to remove heat from the sensor structure 106, irrespective of the detector electronics and the thermal decoupling between the detector electronics and the sensor structure or detector 106. See in this respect the embodiments as exemplified in Figures 6 and 7, and the related description above.

To achieve the decoupling, two technologies are introduced. One is a thermal link (or thermal 'strap'). Another is a flexible cable for electronics.

In an embodiment, the eigenfrequencies of the electronics may be adjusted, by adjusting the connection thereof. Herein, the eigenfrequencies of the electronics can contribute low eigenfrequencies to the base, which typically includes equipment, such as a mirror block or the wafer stage WT. The sensor system 200 of the disclosure enables a vast range of options to mount and connect the electronics, by obviating concerns for bending. The latter increases options for choice of material and design approach.

In a practical embodiment, the thermal link 280 provides a non-stiff, thermally conductive connection. The link can be quantified by measuring or simulating disturbance forces and dynamics of the entire sensor system.

According to embodiments of the present disclosure, the heat sink is thermally disconnected from the detector holder. In accordance with embodiments of the disclosure, detector electronics are mounted to the heat sink and a connection is made between the heat sink and the cooling system. By doing so, the thermal load of the detector electronics can be removed via the heat sink to the cooling system. Herein, the heat load of the detector propagates to the detector holder, which serves as a heat sink for the detector heat load. As the detector holder or carrier structure 102 and the heat 250 sink are thermally disconnected, said heat cannot propagate directly to the heat sink. The thermal link between the detector holder and the cooling system enables the heat load of the sensor or detector to be removed directly to the cooling system. Finally, the flow direction of the cooling medium of the cooling system can be directed first to the thermal link, and secondly to the heat sink. The latter obviates heat from the detector electronics to reach the thermal link and thus from reaching the detector.

The sensor system of the present disclosure provides significant advantages by, for instance, isolating the thermal loop of the electronics from the sensor thermal loop. Herein, the electronics are structurally decoupled from the sensor, to prevent bending effects. This is combined with maintaining a thermal connection to transport any heat away from the sensor carrier to the cooling system. This construction enables to stiffen the electronics, increasing their eigenfrequencies. Also, the construction enables to distribute and thereby reduce the temperatures in the control circuit boards.

In the system of the disclosure, heat originating from the control circuits can be substantially fully decoupled and isolated from the carrier, so that virtually no heat from the printed circuit boards and the related instability can reach the reference marks on the sensor. Thermal bending or deformation in the electronics cannot effect the positioning of the sensor, the sensor is fully decoupled from the electronics.

The eigenfrequencies of the printed circuit boards, i.e. the electronics, can be increased significantly by means of the thermal pads. Embodiments of the disclosure enable the use of the thermal pads, because the heat cup is thermally decoupled from the sensor carrier.

Heat spreading is increased significantly through the thermal pads, so that temperatures in the electronics are generally reduced. As a result, the electronics can now feature higher power consumption than before, and thus also more functionality.

The re-usability of the sensor system is improved, as separate modules allow the sensor side to be replaced while keeping the same electronics.

All the above provide various cost savings. For instance, multiple steps are removed in the fabrication process. As mentioned before, the heat cup can be made from relatively cheap metal, enabling a relatively simple and cost effective sheet metal construction method. Finally, the cooling system can be simplified, only requiring a cooling medium flow circuit. The cooling medium can be any suitable cooling medium, including but not limited to gas, such as hydrogen or helium, or a liquid, such as water, polyalkylene glycol, or another cooling liquid.

The above is enabled by the thermal link 280. These may be made of, in a practical embodiment, by highly conductive sheet foil materials used to provide thermal conductivity while being non-stiff. Examples include copper, aluminium or graphite. In addition, the flexible signal cables interconnecting the control circuits. These allow a non-stiff electrical connection. Finally, the thermal interface material (TIM) pads allow to bridge air gaps, which is especially useful for operation in vacuum.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrates) or mask (or other patterning devices). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. Sensor system for use in a lithographic apparatus, the sensor system comprising:
- a cooling system configured to be embedded in an object table;
- a detector holder provided with a detector and having supports configured to be connected to the object table;
- a heat sink connected to the cooling system, the heat sink being thermally disconnected from the detector holder; and
- detector electronics thermally coupled to the heat sink for processing a detector signal received from the detector.

2. The system of claim 1, comprising a thermal link connected between the detector holder and the cooling system.

3. The system of claim 1 or 2, wherein the detector comprises an image sensor.

4. The system of one of the previous claims, wherein the thermal link is compliant.

5. The system of one of the previous claims, wherein the detector holder and the detector electronics are connected via a flexible cable for transmitting the detector signal.

6. The system of one of the previous claims, wherein the detector holder and the detector electronics are thermally disconnected from each other.

7. The system of one of the previous claims, wherein the heat sink is arranged between the detector holder and the cooling system.

8. The system of one of the previous claims, wherein the cooling system is a cooling medium based cooling system, the cooling system being adapted to direct flow of the cooling medium first for cooling the detector holder and subsequently for cooling the heat sink.

9. The system of one of the previous claims, the cooling system comprising a first cooling section for cooling the detector holder, and a second cooling section connected to the first cooling section for cooling the heat sink.

10. The system of one of the previous claims, comprising a thermal interface material thermally connecting an inner surface of the heat sink to the detector electronics.

11. An object stage, comprising:
- at least one sensor system comprising:
- a cooling system;
- a detector holder provided with a detector and connected to the object stage;
- a heat sink connected to the cooling system, the heat sink being thermally disconnected from the detector holder;
- detector electronics thermally coupled to the heat sink for processing a detector signal received from the detector; and
- a thermal link connected between the detector holder and the cooling system.

12. The object stage of claim 11, wherein the detector of the at least one sensor system is an image sensor.

13. A lithographic apparatus comprising at least one object stage according to claim 11 or 12.

14. The lithographic apparatus of claim 13, comprising a source of radiation for exposure of a pattern on a substrate, the radiation being in the extreme ultraviolet (EUV) spectrum.

15. A method for sensing in a lithographic apparatus, the method comprising:
- providing a substrate stage having at least one sensor system, the sensor system comprising:
- a cooling system;
- a detector holder provided with a detector and connected to the substrate stage;
- a heat sink connected to the cooling system, the heat sink being thermally disconnected from the detector holder;
- detector electronics thermally coupled to the heat sink for processing a detector signal received from the detector; and
- a thermal link connected between the detector holder and the cooling system.

16. The method of claim 15, comprising the step of directing a flow of cooling medium through the cooling system to first cool the thermal link to the detector holder and subsequently to cool the heat sink.
